# EUROPEAN PATENT SPECIFICATION

(11) **EP 0 377 282 B1**
(45) Date of publication and mention of the grant of the patent: **01.02.1995**
(21) Application number: 89312320.8
(22) Date of filing: 28.11.1989
(51) Int. Cl.: G01R 21/133

(54) **Electronic meter digital phase compensation**
Digitale Phasenkompensation für einen elektronischen Zähler
Compensation numérique de phase pour un compteur électronique

(30) Priority: 02.12.1988 US 279178
(43) Date of publication of application: 11.07.1990
(73) Proprietor: GENERAL ELECTRIC COMPANY, Schenectady, NY 12345 (US); SILICON SYSTEMS, INC., Tustin, CA 92680 (US)
(72) Inventor: Germer, Warren Ralph, Dover New Hampshire 03820 (US); Negahban-Hagh, Mehrdad, Irvine California 92714 (US); Ouellette, Maurice Joseph, North Berwick Maine 03906 (US)
(74) Representative: Pratt, Richard Wilson

(56) References cited:
- EP-A- 0 288 413
- DE-A- 2 550 282
- IEEE TRANSACTIONS ON POWER APPARATUS AND SYSTEMS, vol. PAS-103, no. 10, October1984, pages 2919-2926; G.N. STENBAKKEN: "A wideband sampling wattmeter"
- IDEMIDEM
- INTERNATIONAL JOURNAL OF ELECTRONICS, vol. 63, no. 3, September 1987, pages455-461; S.S. OMRAN et al.: "Microcomputer-controlled sampling digital power,rms and PF meter"

## Description

The present invention relates to electronic power metering utilizing digital signal processing and, are particularly, to simplified means to improve the accuracy of such meters by compensating for undesired differences or errors in the phase of the voltage and current signals.

Electronic watthour meters are disclosed, for example, in United States Patents 4,535,287 - Milkovic; 4,556,843 - Milkovic and Bogacki; 4,682,102 - Milkovic; and 4,761,605 - Jochum.

In the present invention, an electronic watthour meter converts analog signals proportional to current voltage in the circuit being metered to digital signals for digital signal processing. The current signals are first converted to voltage signals by a current to voltage converter for compatibility with the analog to digital converters which provide digital signals based on samples of the current and voltage input signals. The conversion of such signals to binary form is based on the amplitude of the current and voltage signals. The digital signals can then be readily multiplied and the product of the multiplication is added to an accumulator which generates pulses proportional to the power use on the power lines being metered. The accuracy of such electronic watthour meters requires that the voltage and current signals be in the correct phase relationship before each is provided to its analog to digital converter. That is, the phase relationship should accurately represent that in the power lines. However, the voltage and current scaling and isolation is accomplished through circuitry including instrument transformers and other circuit elements which may introduce phase differences or errors between them.

In order to obtain the required accuracy, and to compensate for manufacturing tolerances, errors in the instrument transformers and changes in circuit elements with time and/or environmental exposure, it becomes necessary to provide phase adjusting or compensating means for the electronic watthour meter. However, it is important that such conpensating means be simple, inexpensive, stable, and reliable. Power meter users, such as power companies and electrical utilities are used to simple adjustments in present rotating element magnetic watthour meters which require tools no more complex than a screwdriver. The phase adjustment requires effectively compensating for, or shifting the phase of, the voltage signal from the secondary winding of the voltage transformer relative to the current signal from the current sensor the amount of their error phase difference. However, in three phase power meters there are separate current and voltage isolation and scaling transformers for each of the three phases. Conventional phase shifters utilizing a variable resistor and/or variable capacitor for each of the three phases would increase the material cost and complexity (and hence reduce reliability), and would require additional cost and complexity for a technician to perform each adjustment individually, particularly in the field when recalibration may be undertaken by a customer. Moreover, variable RC network phase shifting is not applicable to multiplexed signals in three phase electronic power meters.

IEEE transactions on power apparatus and system volume PAS-103 no. 10, October 1984, pages 2919-2926; G N Stenbakken "A wideband sampling meter" discloses an electronic watthour meter for metering the consumption of electrical energy in power lines comprising first and second analog to digital converters for respectively converting current and voltage signals. A multiplier multiplies the outputs of the converters to provide an electrical energy consumption indication, and a clock provides control signals to the analog to digital converters and a phase shifting means introduces a variable delay into the timing signals for compensation. Nevertheless, further improvements in accuracy of these systems is desirable.

The present invention provides an electronic watthour meter for metering the consumption of electrical energy in polyphase power lines, comprising a current multiplexer connected in matched circuit with each phase of said power lines for providing a multiplexed analog current signal; a first analog to digital converter connected to said current multiplexes for providing a first digital signal response to current flow in each line of said power lines; a voltage multiplexer connected in matched circuit with each phase of said power lines for providing a multiplexed analog voltage signal; a second analog to digital converter connected to said voltage multiplexer for providing a second digital signal in response to voltage applied to each of said power lines; a multiplier for multiplying said first digital signal and said second digital signal to derive an indication of electrical energy consumption on said power lines; and compensation means for providing a first timing signal to said first analog to digital converter and a second timing signal to said second analog to digital converter, said compensation means including phase shifting means for lead or lag phase errors by shifting the timing of said first timing signal relative to that of said second timing signal, to provide said first and second digital signals to said multiplier substantially in phase relationship for all current and voltage phases of said polyphase power lines through use of a single adjustment.

There is disclosed herein a simplified phase adjustment for an electronic power meter, which requires but a single adjustment for multi-phase power circuits, and which is inexpensive, reliable and stable.

In practising the invention, in one embodiment thereof an electronic solid state current multiplexer to combine the signals from individual line currents in each phase, a voltage multiplexer to combine the individual line voltage signals for each phase, current and voltage analog to digital converters for converting each multiplexed signal to digital signal, and a multiplier to multiply the digital signals as an indication of power use on the polyphase power lines. Phase shift compensation means are provided to adjust the timing of the sampling of one multiplexed signal relative to the other to compensate for phase shifts in the system, and provide a more accurate indication of power use on the power lines. The phase shift compensation allows adjustment for either lead or lag phase error differences.
FIG. 1 is a block diagram of an electronic watthour meter in accordance with the present invention;
FIG. 2 is a plot of in-phase current and voltage signals; and
FIG. 3 is a plot of current and voltage signals illustrating a delayed current signal and phase compensation in accordance with the present invention;
FIG. 4 is a diagram of a phase shifting network in accordance with the present invention;
FIG. 5 is a table illustrating the effects of the binary code switching on the phase compensation; and
FIG. 6 is a diagram of a phase locked loop arrangement useful in one embodiment of the present invention.

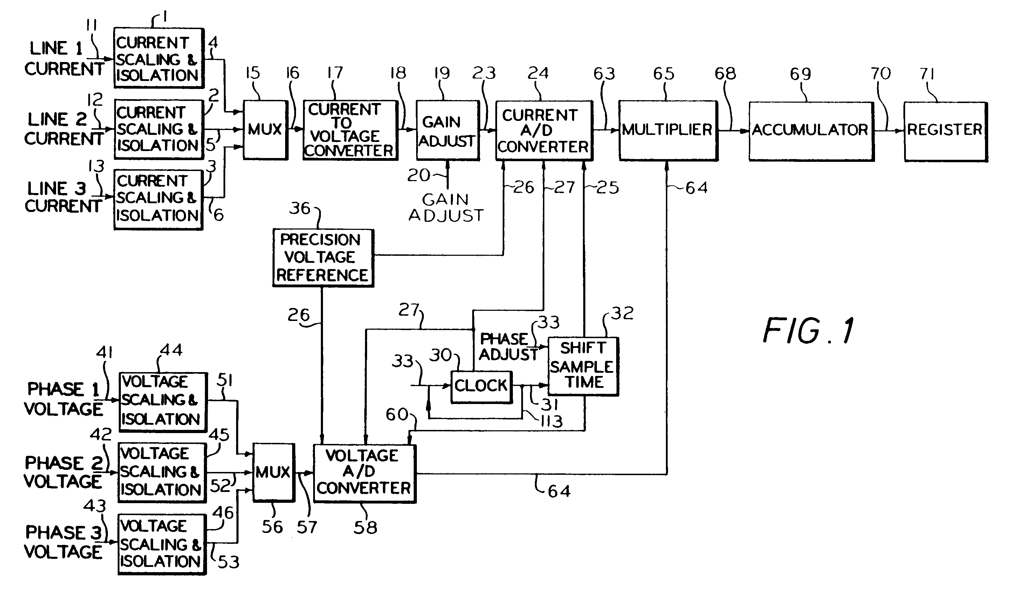

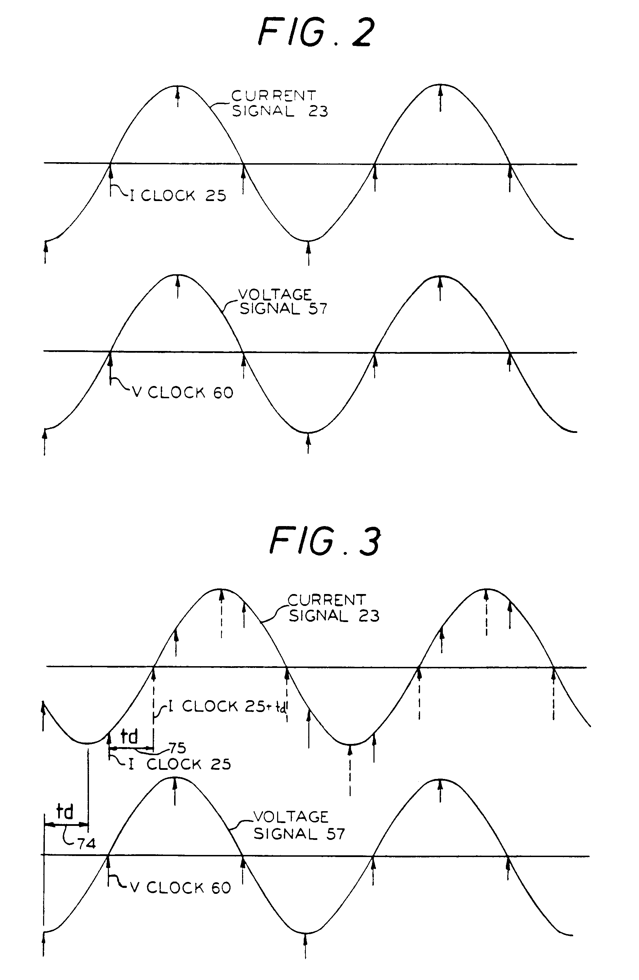

Referring to FIG. 1, there is shown a three phase electronic watthour meter in which three current scaling and isolation means 1, 2 and 3 provide output current signals 4, 5, and 6 respectively, which are proportional to the line currents in power lines 11, 12 and 13 respectively. In order to obtain the desired scaling and isolation, the current scaling and isolation circuits 1, 2, and 3 include current transformers (not shown) which, with the proper turns ratio between the primary and secondary windings, in part provide the desired scaling. In addition, the transformers isolate the solid state circuitry of the electronic power meter from the power lines. The structure and operation of current scaling and isolation means 1, 2 and 3 are described in more detail in our copending European patent application number EP-A-0365216. Current scaling ratios of 100,00-to-one and 10,000-to-one have been selected fro self-contained power meters with full scales of 200 amperes and 20 amperes (transformer rated) meters respectively. Full-scale secondary currents or output signals 4, 5 and 6 are then 2.0 milliamps root means square (rms). In order to minimize the complexity of the electronic circuitry, the scaled output current signals 4, 5 and 6 are provided to current multiplexer 15 where they are sequentially sampled to provide separate time separated sample signals which are proportional to each of the current signals 4, 5, and 6. The multiplexer enables the use of a single data processing channel (described below) for time-sharing all three of the multiplexed and hence time separated current signals 4, 5 and 6 as multiplexed current signal 16. Multiplexed current signal 16 is provided to the input of the current to voltage converter 17, which passes the multiplexed current signal 16 through a current to voltage converter 18 to generate a voltage signal 18 proportional to the multiplexed current signal 16 which is compatible with the analog to digital converter 24 to be described below. The scaling of the current to voltage converter 17 is one volt output signal 18 per one milliamp input signal 16. The voltage signal 18 is fed to the gain adjust circuit 19 which utilizes gain adjust control or potentiometer 20 to vary the gain of an operational amplifier (not shown) and provide the desired amplitude for signal 18 before the gain adjusted current analog signal 23 is fed to the current analog to digital converter or current A/D converter 24. The A/D converter 24 also receives the current or I clock signal 25 and voltage reference signal 26. The I clock signal 25 is a precision timing signal provided by a crystal controlled oscillator or clock 30 which is fed through a shift sample time circuit 32 which includes a phase adjustment means 33 and which is described in more detail below in connection with FIGs. 2, 3, 4 and 5. The voltage reference signal 26 is a stable precision voltage reference provided by a temperature-compensated zener diode in the precision voltage reference circuit 36 and which may be an integrated circuit of the type manufactured by National Semiconductor and identified as their type LM 129.

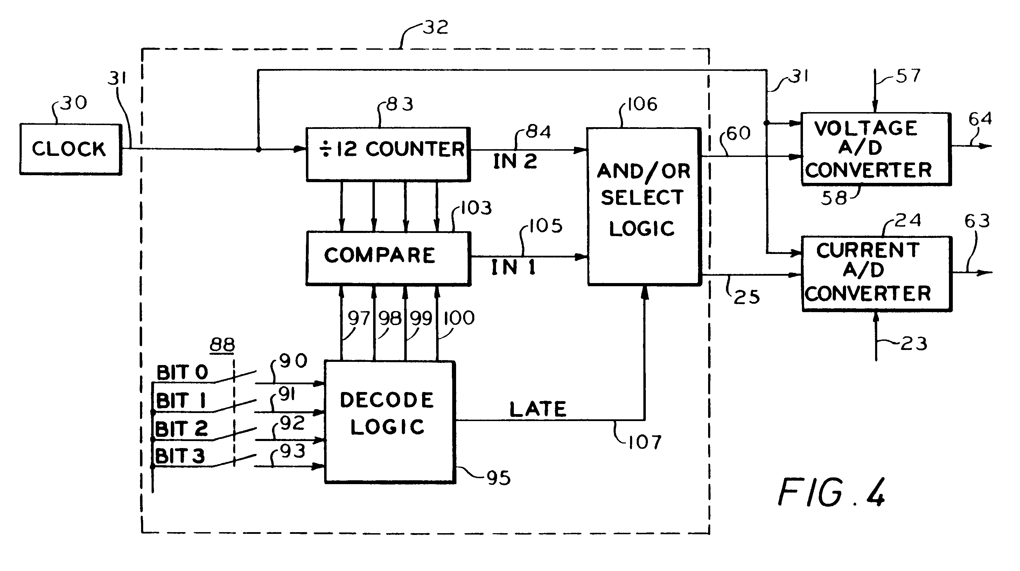

The phase 1 voltage 41, phase 2 voltage 42 and phase 3 voltage 43 are fed through the voltage scaling and isolation circuits or transformer circuits 44, 45 and 46, respectively, to provide voltage scaled and isolated signals 51, 52 and 53 respectively to the voltage multiplexer 56 which provides a voltage multiplexed analog signal 57 to the voltage analog to digital converter, or voltage A/D converter, 58. It is important that the voltage scaling and isolation circuits 44, 45, and 46 be matched such that their phase delay characteristics are equal. Similarly, it is important that the current scaling and isolation circuits 1, 2 and 3 be matched to one another such that their phase delay characteristics are also equal. The voltage A/D converter 58 also receives a voltage reference signal 26 from the precision voltage reference circuit 36 and the voltage clock or V clock signal 60 which is provided by shift sample time circuit 32. In the FIG. 1 embodiment both, A/D converters 24 and 58 have a full-scale range of approximately ± 3.45 volts DC as determined by the voltage reference signal 26. The clock 30 provides precision time base clock signals 27 to control the functioning of the A/D converters 24 and 58 and the shifted time sample clock signals 25 and 60 are at a rate which is one twelfth of the frequency of clock signals 27 as described below in connection with FIG. 4. Signals 25 and 60 establish a constant sample rate at which the A/D converters 24 and 58 "sample" the current and voltage inputs 23 and 57 and convert their amplitudes to binary words. The current and voltage signals 23 and 57 are sampled every twelfth cycle of the clock signal 27. Sample rates in excess of several kilohertz are desired to obtain good performance for harmonics in the input signals 23 and 57. The current A/D converter 24 and the voltage A/D converter 58 provide output signals, namely a digital current signal 63 and a digital voltage signal 64, respectively, which are digital words representative of, and proportional to, their analog inputs, namely the gain adjusted current signal 23 and the voltage multiplexed signal 57, respectively. In the current and voltage A/D converters 24 and 58, upon application of the I clock or timing signal 25 and the V clock or timing signal 60 to the A/D converters respectively, the analog input signals 23 and 57, respectively, are sampled and held with their magnitudes converted into binary form with the voltage reference signal 26 defining the binary magnitudes of the current and voltage signals 23 and 57.

The digital current signal 63 and the digital voltage signal 64 are in the form of binary coded signals or words, such that digital logic or digital signal processing techniques can be used to accomplish the remainder of the metering function. The digital current signal 63 and the digital voltage signal 64 provide the inputs to the multiplier 65 which multiplies each binary coded current sample, with that of its corresponding voltage sample, to provide a digital input signal 68 to the accumulator 69, which input represents their product and which is proportional to power. Samples of the line current 11 of line 1 as it is carried by the multiplexed current signal 16, and samples of phase voltage 41 of phase 1 as it is carried by the multiplexed voltage signal 57 of the power being measured in line 1 are thus multiplied; as are the current and voltage samples of lines 2 and 3. In the case of line 2, it is samples of the line current 12 and the voltage 42 which are multiplied, while in the case of line 3, it is samples of the line current 13 and the voltage 43 which are multiplied.

Each time the accumulated sum of the multiplied voltage and current samples or input 68 reaches a preset threshold value, proportional to the meter watthour constant, an output pulse is generated by the accumulator 69. In one embodiment of the present invention, the rate of output pulse 70 was selected to be twelve times the rate of one disk revolution for an equivalent electromechanical watthour meter. A typical threshold value is 144 (10⁻⁶) volt-ampere-seconds for a one element meter for two-wire single phase applications, and 864 (10⁻⁶) volt-ampere-seconds for three phase applications. The register 71 counts, stores and displays energy information based on the number of pulses 70 that it receives. The register 71, could include a digital display, such as a liquid crystal display (not shown), to display the line power consumption in kilowatt hours.

The accuracy of the energy reading provided by the register 71 is dependent on the current and voltage signals 63 and 64, which are derived from the analog current and voltage signals 23 and 57 respectively, being of the correct phase when multiplied in multiplier 65. Referring to FIG. 2, an ideal phase relationship is shown where the current signal 23 and voltage signal 57 are in phase. As such, no phase shift compensation is required. As a result the A/D conversions of the in phase current and voltage signals 23 and 57 are simultaneously carried out by converters 24 and 58 respectively. This simultaneous conversion is illustrated in FIG. 2 where the I clock 25 and the V clock 60 are coincident with the in phase components of signals 23 amd 57. At the end of the two A/D conversions, the binary outputs 63 and 64 from converters 24 and 57 are thus, each true in phase representations of the in phase analog current and voltage signals 23 and 57 respectively. As a result, when the current signal 63 and voltage signal 64 are multiplied by multiplier 65 an accurate representation of the power consumed by power lines 11, 12 and 13 will be manifested in the binary digital signals 68 from the multiplier 65.

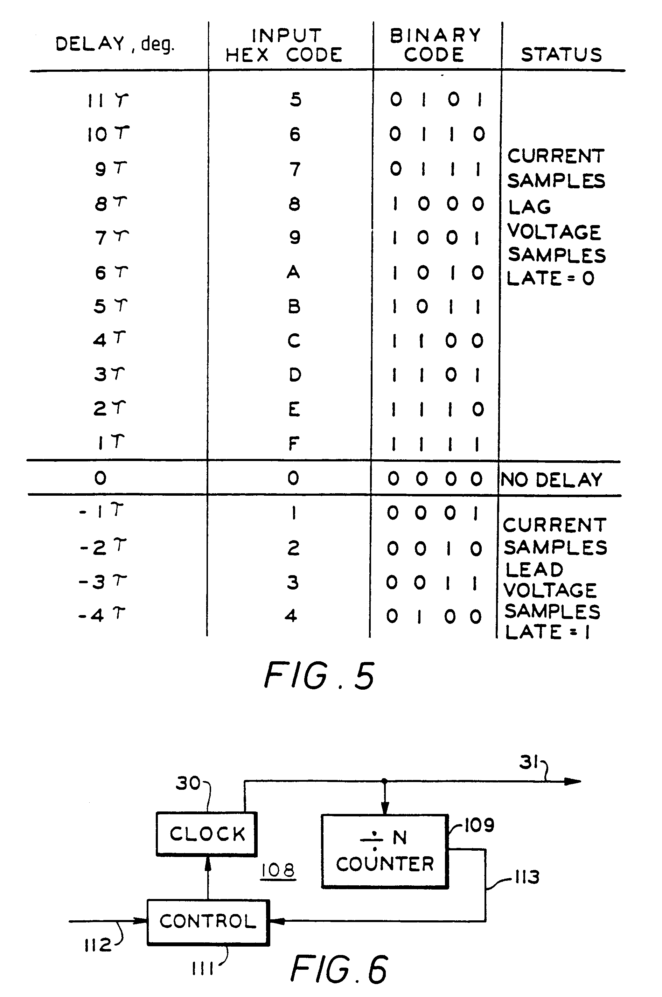

Referring to FIG. 3, it is to be now noted that the current signal 23 has suffered a phase delay in the current circuits, for example, in the current sensors of current scaling and isolation circuits 1, 2 and 3. While the delays encountered in actual use are somewhat exaggerated in FIG. 3, there is a time delay or td 74 such that if the I clock and V clock signals 25 and 60 were simultaneously generated (as in FIG. 2) the current signal 23 would be negative while the voltage signal 57 is positive, thus providing a multiplier output signal 68 which would not be an accurate representation of the real power in lines 11, 12 and 13. The shift sample time circuit 32 can be and is adjusted as described in more detail below in connection with FIGS. 4 and 5 such that the I clock 25 is delayed by the clock delay or td 75 an amount equal to the time delay 74 relative to the V clock 60 such that their timing is corrected relative to the phases of the current and voltage signals 23 and 57. Thus, the time shifted I clock signal 25 and the V clock signal 60 both begin to sample their respective signals, for example, at the instant when both the current signal 23 and voltage signal 57 start positive. In this manner, the sampling period is adjusted to begin at a precise point in time when the current and voltage signals 23 and 57 are in phase. The operation and details of the shift sample time circuit are best discussed with reference to FIGs. 4 and 5.

FIG. 4 shows the details of the digital phase adjustment circuitry. Referring to FIG. 4, the clock 30 provides a 414.6 kilohertz clock signal 31 to counter or divider 83 of shift sample time 32 which divides the signal 31 by twelve providing an output signal 84 which is approximately 34.5 kilohertz. The signal 84 drives the and/or select logic circuit 106 which provides the voltage clock signal 60 at approximately 34.5 kilohertz to the voltage analog to digital converter 58; and also provides a current clock signal 25 at approximately 34.5 kilohertz to the current analog to digital converter 24. The voltage clock signal 60 and the current clock signal 25 are control signals which control when the analog to digital converters 58 and 24 respectively, sample the multiplexed analog input signals, 57 and 23, respectively, and convert the magnitudes of the converter analog input signals 57 and 23 to binary coded outputs, 64 and 63 respectively. Basically, the voltage clock signal 60 and the current clock signal 25 determine the sampling rate, and each conversion process in analog to digital converters, 58 and 24 respectively, is clocked to completion within the twelve clock times or pulses allotted before the next voltage clock signal 60 and the current clock signal 25, respectively.

The phase or timing shift between the voltage clock signal 60 and the current clock signal 25 is set by shift sample time circuit 32. This timing shift is controlled by a phase shift control 88 which is preferably a sixteen position binary-coded switch such as that sold by EECO, Inc., as their model 330035GS. The four bit binary input shown as BIT 0, BIT 1, BIT 2, and BIT 3 provides a four bit signal via inputs 90, 91, 92 and 93 to the decode logic circuit 95. FIG. 5 shows the possible input states (in Hex code and Binary code) for BITS 0-3. FIG. 5 also shows the allocation of which states of BITS 0-3 provide prescribed degrees (given as TAU) of phase delay between the voltage and current clock signals 60 and 25. It should be noted that state 0 (Hex) provides no delay between clock signals 60 and 25, which means that these signals are coincidental in time or phase under that condition. The four bit output of the decode logic circuit 95 is provided to the compare or comparison circuit 103 via outputs 97, 98, 99 and 100. The decode logic circuit 95 decades BITS 0-3 from the binary switch 88 inputs and provides decoded outputs of 97-100, representative of delay as shown in FIG. 5. That is, outputs 97, 98, 99 and 100 define how many steps or states from 0 (Hex) the phase separation (in degrees) should be. Decode logic 95 also decades BITS 0-3 to develop a Late signal 107 from the decodes shown in FIG. 5. The Late signal 107 determines the direction of the phase correction or compensation (ie, whether the current signal 23 is leading or lagging the voltage signal 57). When the counter 83 reaches the state defined by 97, 98, 99 and 100, the output IN1 105 takes place from the compare 103. When the counter 83 reaches its full count, the output IN2 takes place. The output IN1 or clock signal 105 and the output IN2 or clock signal 84 are both approximately 34.5 kilohertz. The output signals 105 and 84 are the input signals to the and/or select logic circuit 106 which also receives the Late signal 107. The Late signal serves as a switching signal to cross switch the IN1 and IN2 signals at the outputs 25 and 60 of the and/or logic 106 to control the sampling start times of the converters 24 and 57. The two clock signals 84 and 105 are logically combined with the Late signal 107 in the and/or select logic circuit 106. When the Late signal 107 is equal to 1, the IN1 signal 105 controls the current or I clock signal 25, and the IN2 signal 84 controls the voltage or V clock signal 60. The V clock signal will be delayed as determined by BIT 0-3 switch settings as shown in FIG. 5. When the Late signal 107 is equal to zero, the IN1 signal 105 is switched in logic 106 to control the voltage or V clock signal 60 and the IN2 signal 84 is switched to control the I clock 25. Thus, the sampling of the current signal 25 in converter 24 is delayed by the amount (in degrees) specified by the time of occurrence of the IN1 signal now applied to the voltage converter 57 (see FIG. 5 for Late = 0).

The details of the time delay or phase shift provided by the shift sample time circuit 32 is explained in further detail in connection with FIG. 5.

Referring to FIG. 5, the table shows the binary codes for the sixteen step, four bit hex-coded rotary switch 88. The zero or 0 delay provides for the situation when there is no delay between the analog input current and voltage signals 23 and 57 to converters 24 and 58 respectively. The 11 switch positions above the zero delay represent steps in situations where the current analog input 23 to the converter 24 lag the analog voltage signal 57 to the converter 58. The 4 switch positions below the 0 delay represent steps in situations where the input current 23 leads the input voltage 57. The rotary switch 88 is conveniently screwdriver actuated to provide delays between the clock timing signals 60 and 25 to the voltage A/D converters of approximately 0.052 degrees per step for a total adjustment range of approximately three-fourths of a degree. The small steps can be very precisely controlled discrete steps based on the frequency of the clock signal 31 from crystal controlled clock 30. It is to be noted that those four steps below the no delay point of FIG. 5 provide timing or clock signals in which the current timing or clock signal 25 precedes the voltage timing or clock signal 60. That is, the sampling of the input current, initiated by the current clock signal 25, leads the sampling of the input voltage initiated by the voltage clock signal 60. Thus, the rotary switch 88 enables a leading or lagging timing or base adjustment to compensate for phase differences which otherwise would introduce errors into the metering. The phase adjustment, being screwdriver actuated can readily be accomplished during manufacture and also during any repair or recalibration undertaken by the customer's service personnel. Moreover, a single adjustment is all that is required to adjust the phases of a multiphase power meter.

There has been provided an effective and simple adjustment to compensate for a number of situations which would otherwise introduce error into the power meter including manufacturing tolerances, changes of circuit parameters with time and/or environmental exposure, and to compensate for errors in other system components, such as the current transformers (not shown) included within the current scaling and isolation circuits 1,2 and 3. In addition,adjustment may be made to conform to different test conditions, and/or with different reference standards. Also, a single screwdriver adjustment effectively compensates for phase errors in all three phases of polyphase meters.

Since the frequency of the power lines 11, 12 and 13 of most commercial power systems is very stable because clocks and other timing devices depend on such accuracies, it may not be necessary to provide compensation for variations in the power line frequency. In the described arrangement, matching the phase of the input signals to the analog to digital converters 24 and 58 is accomplished by shifting the sampling time of the voltage signal 57 relative to the current signal 23. When the power line frequency changes, the fixed amounts shown in FIG. 5 represent a different amount of phase shift. Worst case line frequency variations seldom exceed 0.02 per cent. This typically occurs during periods of low power usage such as nights or weekends when the electric utility is "catching up" on cycles lost during high usage periods. American National Standards Institute (ANSI) standard C12.1 describes a line frequency variation test in which thefrequency is varied plus and minus 5 per cent with a power factor of 1.0. Even in the worst case test condition, the resultant variation in watthour meter calibration at a power factor of 1.0 is probably negligible. In practising the present invention, errors due to line frequency variations may not justify the complexity involved in making the time delays vary with power line frequency variations. However, to the extent such increased accuracy is required, the phase compensation accomplished by the present invention can be made insensitive to line frequency variations by "slaving" the clock 30 to the line frequency through use of a phase locked loop.

FIG. 6 shows a phase locked loop circuit which may be used with the present invention if the additional accuracy is required or desired. A suitable phase-locked loop is disclosed in our United States Patent 4,682,102 - Milkovic. Referring to FIG 6, the oscillator or clock 30 includes the phase locked loop 108. The phase locked loop 108 includes a counter or N divider 109 in series with control circuit 111. The analog line voltage 112 from the power lines is an input to the control circuit 111 along with the feedback signal 113. The dividing rate N of divider 109 and the frequency of clock 30 are selected such that the frequency divided by the dividing rate N equals the frequency of the line voltage 112. That is clock frequency : counter rate N = power line frequency. The control circuit 111 compares the phases of the line voltage 112 and the feedback signal 113 and applies a control signal to clock 30 to effectively lock the frequency of the clock 30 to the desired multiple N of the power line frequency, making the frequency accuracy of the clock 30 equal to the frequency accuracy of the power line frequency 112. It is desirable that N be a large number, in the order of 7000 or more since it is desirable in a digital power meter that the number of output pulses per measurement be sufficiently high to avoid any jitter on the output pulse rate.

While the present invention has been described with respect to certain preferred embodiments thereof, it is to be understood that numerous variations in the details of construction, the arrangement and combination of parts, and the type of materials used may be made without departing from the scope of the invention.

## Claims

1. An electronic watthour meter for metering the consumption of electrical energy in polyphase power lines, comprising :
a current multiplexer (15) connected in matched circuit with each phase of said power lines for providing a multiplexed analog current signal;
a first analog to digital converter (24) connected to said current multiplexer for providing a first digital signal response to current flow in each line of said power lines;
a voltage multiplexer (56) connected in matched circuit with each phase of said power lines for providing a multiplexed analog voltage signal;
a second analog to digital converter (58) connected to said voltage multiplexer for providing a second digital signal in response to voltage applied to each of said power lines;
a multiplier (65) for multiplying said first digital signal and said second digital signal to derive an indication of electrical energy consumption on said power lines; and
compensation means (32) for providing a first timing signal to said first analog to digital converter and a second timing signal to said second analog to digital converter, said compensation means including phase shifting means (32) for lead or lag phase errors by shifting the timing of said first timing signal relative to that of said second timing signal, to provide said first and second digital signals to said multiplier substantially in in-phase relationship for all current and voltage phases of said polyphase power lines through use of a single adjustment.

2. The electronic watthour meter of Claim 1, comprising:
additional compensation means (108) providing insensitivity of said electronic watthour meter to power line frequency variations whereby phase compensation is provided for phase differences in the power line and in the watthour meter circuitry and additional compensation is provided for power line frequency variations.

3. The electronic watthour meter in accordance with Claim 2 wherein said phase shifting means (32) includes means for providing a fixed timing offset plus means for shifting the timing of one of said first and second timing signals to correspond with a shift in the phase of either one of said power line currents and voltages, and said additional compensation (108) includes a phase locked loop.

4. The electronic watthour meter of Claim 1 wherein said compensation means (32) further includes means for cross switching the timing signals provided to said analog to digital converters, and the frequency of said first and second timing signals are very high compared to the frequency on said power lines.

5. The electronic watthour of Claim 4 wherein a current scaling and isolation circuit (1-3, 44-46) is connected in circuit with each phase of said power lines and a voltage scaling and isolation circuit (44-46) is connected in circuit with each phase of said power lines.

6. The electronic watthour meter of Claim 5 wherein a current to voltage converter (17) converts said multiplexed analog current signal to a voltage signal proportional to the multiplexed analog current before said multiplexed analog current signal is applied to said first analog to digital converter (24).

7. The electronic watthour meter of Claim 6 wherein an adjustable gain circuit (19) is provided to adjust the amplitude of the proportional voltage signal prior to the application thereof to said first analog to digital converter.

8. The electronic watthour meter of Claim 7 wherein a precision voltage reference source (36) provides a voltage reference signal to said first analog to digital converter (24) and to said second analog to digital converter (58).

9. The electronic watthour meter of Claim 8 wherein said precision voltage reference source (36) includes a zener diode.

10. The electronic watthour meter of Claim 9 wherein said first and second timing signals are derived from an oscillator.

11. The electronic watthour meter of Claim 1, said timing signals being derived from an oscillator; said oscillator including a phased locked loop (108) whereby the accuracy of said oscillator is made equal to the frequency accuracy of the frequency of said power lines; and where said means to compensate further includes means for cross switching the timing signals provided to said analog to digital converters.

12. The electronic watthour meter of Claim 11 wherein said oscillator is a high frequency oscillator.

13. The electronic watthour meter of Claim 12 wherein the adjustment of the timing signal provided to said current analog to digital converter is performed by a binary coded switch (88).

14. The electronic watthour meter of Claim 13 wherein a fixed timing offset between said timing signals is provided, which timing offset may then be modified by adjustment of said binary coded switch (88).

15. The electronic watthour meter of Claim 14 wherein said binary coded switch provides at least a 4-bit binary code.

16. The electronic watthour meter of Claim 15 wherein the frequency of said oscillator is very high compared to the frequency on said power lines, and includes means (3) for providing high frequency pulses to each of said current and voltage analog to digital converters (24,58) to provide high frequency sampling of the multiplexed current and voltage signals during the periods when the timing signals are provided to said current and voltage analog to digital converters.

17. The electronic watthour meter of Claim 15 wherein said means to compensate includes means responsive to outputs from said binary coded switch to indicate whether said multiplexed current signal is leading or lagging said voltage multiplexed signal.

18. The electronic watthour meter of Claim 17 wherein said binary coded switch (88) may be actuated to change the timing of the sampling of said multiplexed current signal relative to said multiplexed voltage signal to compensate for the phase difference error therebetween.

19. The electronic watthour meter of Claim 12 wherein a fixed offset is provided to the timing of both said timing signals, and said means for adjusting the timing is binary coded to enable adjustment for both lead and lag phase differences.

20. The electronic watthour meter of Claim 12 wherein a fixed offset is provided to the timing of one of said timing signals and said means for adjusting the timing is a binary coded switch to enable adjustment for both lead a lag phase differences.

21. The electronic watthour meter of Claim 12 wherein the frequency of said oscillator is divided by a counter circuit (83) to provide said timing signals at a sub-multiple frequency of said oscillator, which sub-multiple frequency is much higher than the line frequency of said power lines.

22. The electronic watthour meter of Claim 21 wherein a decoding logic circuit (95) provides a signal to selectively control the application of said timing signals to said current and voltage analog to digital converters (24,58).

23. The electronic watthour meter of Claim 22, wherein the contents of a counter in said counter circuit (83) is compared with the binary coded outputs from said decoding logic circuit (95) to provide the amount of delay and direction of change of at least one of said timing signals to compensate for phase differences between the multiplexed current and voltage signals.

24. The electronic watthour meter of Claim 23 wherein the frequency of said oscillator is in excess of 400 kilohertz and said counter circuit divides said oscillator frequency by 12.

25. The electronic watthour meter of Claim 14 wherein the rate of said timing signals are equal at said fixed timing offset.

## Patentansprüche

1. Elektronischer Wattstundenzähler zum Messen des Verbrauchs elektrischer Energie in mehrphasigen Netzleitungen, enthaltend:
einen Strom-Multiplexer (15), der in einer angepaßten Schaltungsanordnung mit jeder Phase der Netzleitungen verbunden ist, zum Liefern eines multiplexierten analogen Stromsignals,
einen ersten Analog/Digital-Wandler (24), der mit dem Strom-Multiplexer verbunden ist, zur Lieferung eines ersten digitalen Signals bei einem Stromfluß in jeder Leitung der Netzleitungen,
einen Spannungs-Multiplexer (56), der in einer angepaßten Schaltungsanordnung mit jeder Phase der Netzleitungen verbunden ist, zur Lieferung eines multiplexierten analogen Spannungssignals,
einen zweiten Analog/Digital-Wandler (58), der mit dem Spannungs-Multiplexer verbunden ist, zur Lieferung eines zweiten digitalen Signals bei einer Spannung, die an jede der Netzleitungen angelegt ist,
einen Multiplizierer (65) zum Multiplizieren des ersten digitalen Signals und des zweiten digitalen Signals, um eine Angabe des elektrischen Energieverbrauches an den Netzleitungen abzuleiten, und
eine Kompensationseinrichtung (32) zur Lieferung eines ersten Zeitsteuersignals an den ersten Analog/Digital-Wandler und eines zweiten Zeitsteuersignals an den zweiten Analog/Digital-Wandler, wobei die Kompensationseinrichtung eine Phasenschiebereinrichtung (32) aufweist für Voreilungs- oder Nacheilungs-Phasenfehler durch Verschieben der Zeitsteuerung des ersten Zeitsteuersignals relativ zu derjenigen des zweiten Zeitsteuersignals, um die ersten und zweiten digitalen Signale an den Multiplizierer in einer im wesentlichen gleichphasigen Relation für alle Strom- und Spannungsphasen der mehrphasigen Netzleitungen durch Verwendung einer einzigen Einstellung zu liefern.

2. Elektronischer Wattstundenzähler nach Anspruch 1, enthaltend:
eine zusätzliche Kompensationseinrichtung (108) zur Ausbildung von Unempfindlichkeit des elektronischen Wattstundenzählers gegenüber Netzleitungs-Frequenzschwankungen, wobei für eine Phasenkompensation für Phasenunterschiede in der Netzleitung und in der Schaltungsanordnung des Wattstundenzählers gesorgt wird, und für eine zusätzliche Kompensation wird für Netzleitungs-Frequenzschwankungen gesorgt.

3. Elektronischer Wattstundenzähler nach Anspruch 2, wobei die Phasenschiebereinrichtung (32) Mittel zur Ausbildung eines festen Zeitsteuer-Offsets und Mittel enthält zum Verschieben der Zeitsteuerung von einem der ersten und zweiten Zeitsteuersignale, um einer Verschiebung in der Phase der Netzleitungsströme oder -spannungen zu entsprechen, und wobei die zusätzliche Kompensation (108) eine phasenstarre Schleife enthält.

4. Elektronischer Wattstundenzähler nach Anspruch 1, wobei die Kompensationseinrichtung (32) ferner Mittel enthält für eine Kreuzschaltung der Zeitsteuersignale, die an die Analog/Digital-Wandler geliefert werden, und wobei die Frequenz der ersten und zweiten Zeitsteuersignale sehr hoch ist im Vergleich zur Frequenz auf den Netzleitungen.

5. Elektronischer Wattstundenzähler nach Anspruch 4, wobei eine Stromskalierungs- und trennschaltung (1-3, 44-46) in den Stromkreis mit jeder Phase der Netzleitung geschaltet ist, und eine Spannungsskalierungs- und trennschaltung (44-46) in einen Stromkreis mit jeder Phase der Netzleitungen geschaltet ist.

6. Elektronischer Wattstundenzähler nach Anspruch 5, wobei ein Strom/Spannungswandler (17) das multiplexierte analoge Stromsignal in ein Spannungssignal proportional zu dem multiplexierten analogen Strom umwandelt, bevor das multiplexierte analoge Stromsignal an den ersten Analog/Digital-Wandler (24) angelegt wird.

7. Elektronischer Wattstundenzähler nach Anspruch 6, wobei eine einstellbare Verstärkungsschaltung (19) vorgesehen ist, um die Amplitude des proportionalen Spannungssignals einzustellen, bevor es an den ersten Analog/Digital-Wandler angelegt wird.

8. Elektronischer Wattstundenzähler nach Anspruch 7, wobei eine Präzisions-Spannungsreferenzquelle (36) ein Spannungs-Referenzsignal an den ersten Analog/Digital-Wandler (24) und an den zweiten Analog/Digital-Wandler (58) liefert.

9. Elektronischer Wattstundenzähler nach Anspruch 8, wobei die Präzisions-Spannungsreferenzquelle (36) eine Zener-Diode aufweist.

10. Elektronischer Wattstundenzähler nach Anspruch 9, wobei die ersten und zweiten Zeitsteuersignale von einem Oszillator abgeleitet werden.

11. Elektronischer Wattstundenzähler nach Anspruch 1, wobei die Zeitsteuersignale von einem Oszillator abgeleitet werden, der eine phasenstarre Schleife (108) enthält, wodurch die Genauigkeit des Oszillators gleich der Frequenzgenauigkeit der Frequenz der Netzleitungen gemacht wird, und wobei die Einrichtung zum Kompensieren ferner Mittel enthält für eine Kreuzschaltung der Zeitsteuersignale, die an die Analog/Digital-Wandler geliefert werden.

12. Elektronischer Wattstundenzähler nach Anspruch 11, wobei der Oszillator ein Hochfrequenz-Oszillator ist.

13. Elektronischer Wattstundenzähler nach Anspruch 12, wobei die Einstellung des Zeitsteuersignals, das an den Strom-Anaolg/Digital-Wandler geliefert wird, durch einen binär kodierten Schalter (88) ausgeführt wird.

14. Elektronischer Wattstundenzähler nach Anspruch 13, wobei ein fester Zeitsteuer-Offset zwischen den Zeitsteuersignalen ausgebildet wird, wobei dieser Zeitsteuer-Offset dann durch Einstellung des binär kodierten Schalters (88) modifiziert werden kann.

15. Elektronischer Wattstundenzähler nach Anspruch 14, wobei der binär kodierte Schalter wenigstens einen 4-Bit-Binärcode liefert.

16. Elektronischer Wattstundenzähler nach Anspruch 15, wobei die Frequenz des Oszillators sehr hoch ist im Vergleich zu der Frequenz auf den Netzleitungen und wobei Mittel (3) vorgesehen sind zu Lieferung hochfrequenter Pulse an jeden der Strom- und Spannungs-Analog/Digital-Wandler (24, 58), um für eine hochfrequente Abstastung (Sampling) der multiplizierten Strom- und Spannungssignale während der Perioden zu sorgen, wenn die Zeitsteuersignale an die Strom- und Spannungs-Analog/Digital-Wandler geliefert werden.

17. Elektronischer Wattstundenzähler nach Anspruch 15, wobei die Einrichtung zum Kompensieren auf die Ausgangsgrößen aus dem binär kodierten Schalter entsprechende Mittel aufweist, um anzuzeigen, ob das multiplexierte Stromsignal dem multiplexierten Spannungssignal voreilt oder nacheilt.

18. Elektronischer Wattstundenzähler nach Anspruch 17, wobei der binär kodierte Schalter (88) betätigt werden kann, um die Zeitsteurung der Abtastung (Sampling) des multiplexierten Stromsignals relativ zu dem multiplexierten Spannungssignal zu ändern, um den dazwischen bestehenden Phasendiffernzfehler zu kompensieren.

19. Elektronischer Wattstundenzähler nach Anspruch 12, wobei ein fester Offset für die Zeitsteuerung beider Zeitsteuersignale ausgebildet wird und die Einrichtung zum Einstellen der Zeitsteuerung binär kodiert ist, um eine Einstellung für sowohl Voreilungs- als auch Nacheilungs-Phasendifferenzen zu ermöglichen.

20. Elektronischer Wattstundenzähler nach Anspruch 12, wobei ein fester Offset für die Zeitsteuerung von einem der Zeitsteuersignale ausgebildet wird und die Einrichtung zum Einstellen der Zeitsteuerung ein binär kodierter Schalter ist, um eine Einstellung für sowohl Voreilungs- als auch Nacheilungs-Phasendifferenzen zu ermöglichen.

21. Elektronischer Wattstundenzähler nach Anspruch 12, wobei die Frequenz des Oszillators durch eine Zählerschaltung (83) dividiert wird, um die Zeitsteuersignale mit einer einem Untervielfachen entsprechenden Frequenz des Oszillators zu liefern, wobei die dem Untervielfache entsprechende Frequenz viel höher ist als die Netzfrequenz der Netzleitungen.

22. Elektronischer Wattstundenzähler nach Anspruch 21, wobei eine dekodierende Logikschaltung (95) ein Signal liefert zur selektiven Steuerung der Zufuhr der Zeitsteuersignale zu den Strom- und Spannungs-Analog/Digital-Wandlern (24, 58).

23. Elektronischer Wattstundenzähler nach Anspruch 22, wobei der Inhalt eines Zählers in der Zählerschaltung (83) mit den binär kodierten Ausgangsgrößen aus der Dekodier-Logikschaltung (95) verglichen wird, um die Größe der Verzögerung und die Richtung der Änderung von wenigstens einem der Zeitsteuersignale auszubilden, um Phasendifferenzen zwischen den multiplexierten Strom- und Spannungssignalen zu kompensieren.

24. Elektronischer Wattstundenzähler nach Anspruch 23, wobei die Frequenz des Oszillators mehr als 400kHz beträgt und die Zählerschaltung die Oszillatorfrequenz durch 12 dividiert.

25. Elektronischer Wattstundenzähler nach Anspruch 14, wobei die Rate der Zeitsteuersignale an dem feststehenden Zeitsteuer-Offset gleich sind.

## Revendications

1. Wattheuremètre électronique pour mesurer la consommation d'énergie électrique dans des lignes de transport d'énergie polyphasée, comprenant:
un multiplexeur (15) connecté, dans un circuit adapté, à chaque phase desdites lignes de transport d'énergie pour fournir un signal de courant analogique multiplexé,
un premier convertisseur analogique-numérique (24) connecté audit multiplexeur de courant pour fournir un premier signal numérique en réponse à une circulation de courant dans chaque ligne desdites lignes de transport d'énergie;
un multiplexeur de tension (56) connecté, dans un circuit adapté, à chaque phase desdites lignes de transport d'énergie pour fournir un signal de tension analogique multiplexé;
un second convertisseur analogique-numérique (58) connecté audit multiplexeur de tension pour fournir un second signal numérique en réponse à une tension appliquée à chacune desdites lignes de transport d'énergie;
un multiplicateur (65) pour multiplier ledit premier signal numérique et ledit second signal numérique pour donner une indication de la consommation d'énergie électrique sur lesdites lignes de transport d'énergie;
un moyen de compensation (32) pour fournir un premier signal de synchronisation audit premier convertisseur analogique-numérique et un second signal de synchronisation audit second convertisseur analogique-numérique, ledit moyen de compensation comprenant un moyen de déphasage (32) pour des erreurs d'avance ou de retard de phase par décalage de la synchronisation dudit premier signal de synchronisation par rapport à celle dudit signal de synchronisation, de manière à fournir lesdits premier et second signaux numériques audit multiplicateur sensiblement dans une relation de phase pour toutes les phases de courant et de tension desdites lignes de transport d'énergie polyphasée par utilisation d'un seul réglage.

2. Wattheuremètre électronique selon la revendication 1, comprenant: un moyen de compensation supplémentaire (108) assurant une insensibilité dudit wattheuremètre électronique aux variations de fréquence dans les lignes de transport d'énergie, grâce à quoi une compensation de phase est assurée pour des différences de phase dans les lignes de transport d'énergie et dans l'ensemble des circuits du wattheuremètre, et une compensation supplémentaire est assurée pour des variations de fréquence dans les lignes de transport d'énergie.

3. Wattheuremètre selon la revendication 2, dans lequel ledit moyen de déphasage (32) comprend un moyen pour assurer un décalage de synchronisation fixe ainsi qu'un moyen pour décaler la synchronisation d'un desdits premier et second signaux de synchronisation de manière qu'elle corresponde avec le décalage de l'un ou l'autre desdits courant et tension des lignes de transport d'énergie et ledit moyen de compensation supplémentaire (108) comprend une boucle de verrouillage de phase.

4. Wattheuremètre électronique selon la revendication 1, dans lequel ledit moyen de compensation (32) comprend, en outre, un moyen pour permuter les signaux de synchronisation fournis audit convertisseur analogique-numérique, et la fréquence desdits premier et second signaux de synchronisation est très élevée par rapport à la fréquence dans lesdites lignes de transport d'énergie.

5. Wattheuremètre électronique selon la revendication 4, dans lequel un circuit d'isolation et de proportionnement de courant (1-3, 44-46) est monté dans chaque phase desdites lignes de transport d'énergie et un circuit d'isolation et de proportionnement de tension (44-46) est monté dans chaque phase desdites lignes de transport d'énergie.

6. Wattheuremètre électronique selon la revendication 5, dans lequel un convertisseur de courant-tension (17) convertit ledit signal de courant analogique multiplexé en un signal de tension proportionnel au courant analogique multiplexé avant que ledit signal analogique multiplexé soit appliqué audit premier convertisseur analogique-numérique (24).

7. Wattheuremètre électronique selon la revendication 6, dans lequel un circuit de réglage de gain (19) est présent pour régler l' amplitude du signal de tension proportionnel avant son application audit premier convertisseur analogique-numérique.

8. Wattheuremètre électronique selon la revendication 7, dans lequel une source (36) de tension de référence de précision fournit un signal de tension de référence audit premier convertisseur analogique-numérique (24) et audit second convertisseur analogique-numérique (58).

9. Wattheuremètre électronique selon la revendication 8, dans lequel ladite source (36) de tension de référence de précision comprend une diode zener.

10. Wattheuremètre électronique selon la revendication 9, dans lequel lesdits premier et second signaux de synchronisation sont fournis par un oscillateur.

11. Wattheuremètre électronique selon la revendication 1, dans lequel lesdits signaux de synchronisation sont fournis par un oscillateur; ledit oscillateur comprenant une boucle de verrouillage de phase (108) grâce à laquelle la précision dudit oscillateur est rendue égale à la précision de la fréquence desdites lignes de transport d'énergie; et ledit moyen de compensation comprend, en outre, un moyen pour permuter les signaux de synchronisation fournis dans lesdits convertisseurs analogiques-numériques.

12. Wattheuremètre électronique selon la revendication 11, dans lequel ledit oscillateur est un oscillateur haute fréquence.

13. Wattheuremètre électronique selon la revendication 12, dans lequel le réglage du signal de synchronisation fourni audit convertisseur analogique-numérique est effectué à l'aide d'un commutateur (88) codé en binaire.

14. Wattheuremètre électronique selon la revendication 13, dans lequel est assuré un décalage fixe de synchronisation entre lesdits signaux de synchronisation, ce décalage de synchronisation pouvant ensuite être modifié par réglage dudit commutateur (88) codé en binaire.

15. Warttheuremètre électronique selon la revendication 14, dans lequel ledit interrupteur codé en binaire fournit au moins un code binaire à 4 bits.

16. Wattheuremètre électronique selon la revendication 15, dans lequel la fréquence dudit oscillateur est très élevée en comparaison de la fréquence dans lesdites lignes de transport d'énergie, et comprend un moyen (3) pour fournir des impulsions haute fréquence à chacun desdits convertisseurs analogiques-numériques de courant et de tension (24, 58) de manière à assurer un échantillonnage de fréquence des signaux de courant et de tension multiplexés pendant les périodes durant lesquelles les signaux de synchronisation sont fournis auxdits convertisseurs analogiques-numériques de courant et de tension.

17. Wattheuremètre électronique selon la revendication 15, dans lequel ledit moyen de compensation comprend un moyen réagissant aux signaux de sortie du commutateur codé en binaire en indiquant si oui ou non ledit signal de courant multiplexé précède ledit signal de tension multiplexé ou lui succède.

18. Wattheuremètre électronique selon la revendication 17, dans lequel ledit commutateur (88) codé en binaire peut être actionné de manière à modifier la synchronisation de l'échantillonnage dudit signal de courant multiplexé par rapport audit signal de tension multiplexé afin de compenser l'erreur de différence de phase entre ces signaux.

19. Wattheuremètre électronique selon la revendication 12, dans lequel un décalage fixe est appliqué à la synchronisation des deux signaux de synchronisation précités et ledit moyen de réglage de synchronisation est codé en binaire pour permettre un réglage à la fois de la différence de déphasage en avant et de la différence de déphasage en arrière.

20. Wattheuremètre électronique selon la revendication 12, dans lequel un décalage fixe est appliqué à la synchronisation d'un desdits signaux de synchronisation et ledit moyen de réglage de synchronisation est un commutateur codé en binaire pour permettre le réglage à la fois de la différence de phase en avant et de la différence de phase en arrière.

21. Wattheuremètre électronique selon la revendication 12, dans lequel la fréquence dudit oscillateur est divisée par un circuit de comptage (83) pour fournir lesdits signaux de synchronisation à une fréquence sous-multiple de celle dudit oscillateur, cette fréquence sous-multiple étant beaucoup plus élevée que la fréquence dans lesdites lignes de transport d'énergie.

22. Wattheuremètre électronique selon la revendication 21, dans lequel un circuit logique de décodage (95) fournit un signal pour commander sélectivement l'application desdits signaux de synchronisation audit convertisseur analogique-numérique de courant et de tension (24, 58).

23. Wattheuremètre électronique selon la revendication 22, dans lequel le contenu d'un compteur dans ledit circuit de comptage (83) est comparé avec les signaux de sortie codés en binaire dudit circuit logique de décodage (95) pour fournir la quantité de retard et la direction de variation d'au moins un desdits signaux de synchronisation pour compenser les différences de phases entre les signaux de courant et de tension multiplexés.

24. Wattheuremètre électronique selon la revendication 23, dans lequel la fréquence dudit oscillateur est supérieure à 400KHz et ledit circuit de comptage divise ladite fréquence de l'oscillateur par 12.

25. Wattheuremètre électronique selon la revendication 14, dans lequel la cadence desdits signaux de synchronisation est égale audit décalage de synchronisation fixe.
